# EUROPÄISCHE PATENTSCHRIFT

(11) **EP 2 807 288 B1**
(45) Veröffentlichungstag und Bekanntmachung des Hinweises auf die Patenterteilung: **30.12.2020**
(21) Anmeldenummer: 13719416.3
(22) Anmeldetag: 02.04.2013
(51) Int. Cl.: C23C 28/04, C23C 14/06, F01D 5/28

(54) **STRÖMUNGSMASCHINENKOMPONENTE MIT EINER FUNKTIONSBESCHICHTUNG**
TURBOMACHINE COMPONENT WITH A FUNCTIONAL COATING
COMPOSANT DE TURBOMACHINE À REVÊTEMENT FONCTIONNEL

(30) Priorität: 16.04.2012 EP 12164302
(43) Veröffentlichungstag der Anmeldung: 03.12.2014
(73) Patentinhaber: Siemens Aktiengesellschaft, 80333 München (DE)
(72) Erfinder: BARNIKEL, Jochen, 45470 Mülheim an der Ruhr (DE); BÖHME, Christian, 47638 Straelen (DE); KERN, Torsten-Ulf, 46485 Wesel (DE); SCHÜRHOFF, Jörg, 45479 Mülheim a.d. Ruhr (DE); SHENG, Shilun, 46149 Oberhausen (DE); DE LAZZER, Armin, 45479 Mülheim an der Ruhr (DE)
(86) Internationale Anmeldenummer: PCT/EP2013/056855
(87) Internationale Veröffentlichungsnummer: WO 2013/156296

(56) Entgegenhaltungen:
- EP-A1- 2 230 330
- WO-A1-2010/133244
- DE-A1- 19 607 736
- DE-A1-102008 019 891
- DE-A1-102008 020 607
- US-A- 5 415 706
- US-A1- 2009 123 737

## Beschreibung

Die Erfindung betrifft eine Strömungsmaschinenkomponente mit einer Funktionsbeschichtung.

In einer Dampfturbine wird zur Erzeugung von Rotationsenergie Wasserdampf entspannt. Die Dampfturbine weist eine Mehrzahl von Stufen auf, wobei jede Stufe einen Leitschaufelkranz mit einer Mehrzahl an Leitschaufeln und einen Laufschaufelkranz mit einer Mehrzahl an Laufschaufeln aufweist. Die Laufschaufeln sind an der Welle der Dampfturbine angebracht und rotieren im Betrieb der Dampfturbine, die Leitschaufeln sind an dem Gehäuse der Dampfturbine angebracht und stehen fest.

Die Schaufeln sind dabei im Betrieb der Dampfturbine verschiedenen Degradationsprozessen ausgesetzt, wie beispielsweise einem Kriechen. Das Kriechen ist eine langsam ablaufende plastische Verformung der Schaufel unter Einwirkung einer Last bei einer erhöhten Temperatur. Die Last kann beispielsweise von dem in der Dampfturbine strömenden Wasserdampf herrühren und bei den Laufschaufeln durch die Fliehkraft aufgrund ihrer Rotation hervorgerufen sein. Weiterhin können die Oberflächen der Schaufeln bei entsprechend hohen Temperaturen in Anwesenheit von Wasserdampf oxidieren, wobei derartig hohe Temperaturniveaus regelmäßig in einer Hochdruckdampfturbine oder in einer Mitteldruckdampfturbine erreicht werden und typischerweise mehr als 540°C betragen.

Im dem Fall, dass sich auf den Oberflächen der Laufschaufeln und/oder der Leitschaufeln eine Oxidschicht gebildet hat, können sich an den Oberflächen Mikrokerben oder Mikrorisse bilden. Dadurch wird die Festigkeit der Laufschaufeln und/oder der Leitschaufeln reduziert, so dass beispielsweise die Biegewechselfestigkeit der Laufschaufeln und/oder der Leitschaufeln herabgesetzt oder zumindest beeinflusst ist. Herkömmlich werden zur Vermeidung der Oxidation die Laufschaufeln und/oder die Leitschaufeln aus kostenintensiven Legierungen hergestellt.

Aus der US 2009/123737 A1 sind Strömungsmaschinenkomponenten mit einem Chromstahl aufweisenden Grundkörper bekannt. Der Grundkörper ist mit einer nitrierten Hartschicht beschichtet. Darauf ist durch Gasphasenabscheidung eine Chromnitrid aufweisende Schicht aufgebracht.

Aus der DE 10 2008 020 607 A1 ist ein Gegenstand mit einer ersten Oberfläche und einer darauf aufgebrachten Beschichtung bekannt. Die Beschichtung umfasst eine erste Chromnitrid aufweisende Schicht, auf der eine weitere Schicht aufgebracht ist.

Aus der DE 10 2008 019 891 A1 ist eine Erosionsschutzbeschichtung insbesondere für Gasturbinenbauteile bekannt. Die Beschichtung weist dabei abwechselnd relativ harte und relativ weiche Schichten auf. Zur besseren Haftung ist unmittelbar am Gasturbinenbauteil eine Chromnitrid aufweisende Haftvermittlungsschicht vorgesehen.

Aus der EP 2 230 330 A1 ist ein Kunststoffbauteil mit einer Erosionsschutzschicht für Anwendungen mit erosiver Beanspruchung bekannt. Bei der Erosionsschutzbeschichtung handelt es sich um ein Mehrlagenschichtsystem mit einer Lage aus einem Metall und einer Lage aus Keramik oder um unterschiedlich harte Keramikschichten.

Aufgabe der Erfindung ist es, eine Strömungsmaschinenkomponente zu schaffen, bei der die oben genannten Probleme überwunden sind und die eine gute Beständigkeit gegen Oxidation sowie eine lange Lebensdauer hat.

Die erfindungsgemäße Strömungsmaschinenkomponente weist einen Chromstahl aufweisenden Grundkörper und eine auf den Grundkörper unmittelbar aufgebrachte Mehrlagenbeschichtung auf, die minimal 5 µm und maximal 35 µm dick ist sowie eine Mehrzahl von unmittelbar aufeinander aufgebrachter Schichten aufweist, wobei die unmittelbar auf den Grundkörper aufgebrachte Schicht eine Haftvermittlerschicht ist, die Chromnitrid aufweist, und mindestens eine der verbliebenen Schichten einen Hartstoff aufweist, der Chromnitrid, Chromaluminiumnitrid und/oder Titanaluminiumnitrid aufweist. Die Mehrlagenbeschichtung wird auch als Funktionsbeschichtung bezeichnet. Die Mehrlagenbeschichtung hat eine gute Beständigkeit gegenüber Oxidation und schützt damit auch den Grundkörper vor der Oxidation. Mit der Mehrlagenbeschichtung kann der Grundkörper einer höheren Temperatur ausgesetzt sein, ohne dass eine signifikante Oxidation des Grundkörpers auftritt, als es ohne die Mehrlagenbeschichtung möglich wäre. Die Mehrlagenbeschichtung kann den Grundkörper vollständig bedecken oder sie kann lediglich auf die Stellen aufgebracht sein, die im Betrieb der Strömungsmaschine unmittelbar einem korrosiven Medium ausgesetzt sind. Handelt es sich bei der Strömungsmaschinenkomponente beispielsweise um eine Laufschaufel oder eine Leitschaufel, ist es ausreichend, die Mehrlagenbeschichtung auf dem Schaufelblatt der Laufschaufel bzw. der Leitschaufel vorzusehen und den Schaufelfuß der Laufschaufel bzw. der Leitschaufel frei zu lassen.

Durch das Vorsehen der Haftvermittlerschicht hat die Mehrlagenbeschichtung vorteilhaft eine gute Anbindung der Mehrlagenbeschichtung an den Grundkörper, wodurch die Mehrlagenbeschichtung eine hohe Festigkeit gegen Ablösung hat. Indem die Mehrlagenbeschichtung lediglich maximal 35 µm dick ausgeführt ist, ergibt sich vorteilhaft eine vernachlässigbare Beeinflussung der Strömung in der Strömungsmaschine. Folgegemäß braucht bei der Auslegung der Strömungsmaschinenkomponente die Mehrlagenbeschichtung nicht berücksichtigt werden. Durch die Mehrlagenbeschichtung erfolgt vorteilhaft keine Beeinflussung der mechanischen Eigenschaften des Grundkörpers, insbesondere seiner Festigkeit gegen Kriechen und gegen Ermüdung. Neben der Beständigkeit gegen Oxidation hat die Strömungsmaschinenkomponente auch eine hohe Beständigkeit gegen Partikelerosion. Die Partikelerosion kann auftreten, wenn Partikel von der Strömung im Betrieb der Strömungsmaschinenkomponente mitgetragen werden und auf die Oberfläche der Strömungsmaschinenkomponente prallen. Dies ist insbesondere relevant bei Laufschaufeln, weil hier aufgrund der Rotation der Laufschaufeln die Relativgeschwindigkeit zwischen den Partikeln und den Laufschaufeln besonders hoch ist und die Partikel daher mit einer besonders hohen kinetischen Energie auf die Laufschaufeln aufprallen.

Der Grundkörper weist erfindungsgemäß einen Chromstahl auf. Alternativ könnte der Grundkörper auch einen austenitischen Stahl und/oder eine Nickel-Basislegierung aufweisen. Diese Materialien haben vorteilhaft eine hohe Beständigkeit gegen Schwingungsbeanspruchungen und gegen Kriechen. Erfindungsgemäß weist der Hartstoff Chromnitrid, Chromaluminiumnitrid und/oder Titanaluminiumnitrid auf. Der Massengehalt an Chrom in dem Chromstahl beträgt bevorzugt minimal 8% und maximal 13%. Der Chromstahl ist bevorzugt ein martensitischer Chromstahl. Der martensitische Chromstahl mit dem Massengehalt an Chrom von 8% bis 13% hat vorteilhaft eine hohe Festigkeit gegenüber Schwingungen und eine hohe Beständigkeit gegenüber Kriechen.

Es ist bevorzugt, dass der Chromstahl Stickstoff aufweist. Bevorzugtermaßen beträgt der Massengehalt an Stickstoff in dem Chromstahl minimal 0,010% und maximal 0,080%. Bei dem Aufbringen der Haftvermittlerschicht auf den Grundkörper kann es zu einer Diffusion von Atomen von der Haftvermittlerschicht in den Grundkörper und umgekehrt kommen. Durch das Vorsehen von Stickstoff in dem Grundkörper dringen bei der Diffusion keine fremden Elemente in den oberflächennahen Bereich des Grundkörpers ein, so dass Gefügeänderungen des Grundkörpers bei dem Aufbringen der Haftvermittlerschicht vorteilhaft unterbunden sind. Der Chromstahl weist weiterhin bevorzugt Molybdän und/oder Vanadium auf. Der Chromstahl weißt bevorzugt von 9,0 bis 11,0 Massenprozent Chrom, von 1,0 bis 2,0 Massenprozent Molybdän, von 0,1 bis 1,0 Massenprozent Nickel und von 0,10 bis 0,30 Massenprozent Vanadium auf. Der restliche Bestandteil ist bevorzugt im Wesentlichen Eisen. Bevorzugtermaßen sind die Schichten der Mehrlagenbeschichtung mittels eines physikalischen Gasphasenabscheideverfahrens (englisch: physical vapour deposition, PVD) aufgebracht. Dadurch ergibt sich vorteilhaft eine geringe gemittelte Oberflächenrauheit R_{z} der aufgebrachten Schichten, die kleiner gleich 2,5 ist. Das physikalische Gasphasenabscheideverfahren wird bevorzugt bei einer Beschichtungstemperatur von niedriger als 600°C durchgeführt. Diese Beschichtungstemperatur liegt vorteilhaft unterhalb der Anlasstemperatur des Chromstahls, wodurch keine oder kaum Veränderungen der mechanischen Eigenschaften, insbesondere der Eigenspannungen, des Grundkörpers beim Aufbringen der Mehrlagenbeschichtung stattfinden. Des Weiteren erfolgt vorteilhaft beim Aufbringen kein Verzug der Strömungsmaschinenkomponente. Versuche an Probekörpern mit und ohne die Mehrlagenbeschichtung haben ergeben, dass sich durch die Mehrlagenbeschichtung keine Verschlechterung der Festigkeit des Grundkörpers gegenüber Schwingungen ergibt.

Bevorzugtermaßen ist die Strömungsmaschinenkomponente eine Komponente einer Dampfturbine. Oxidation ist insbesondere ein Problem in Anwesenheit von Wasserdampf, so dass die erfindungsgemäße Strömungsmaschinenkomponente vorzusehen in einer Dampfturbine besonders vorteilhaft ist. Die Strömungsmaschinenkomponente ist bevorzugt eine Schaufel. Die Schaufel ist ein besonders stark beanspruchtes Bauteil, insbesondere durch Schwingungen, so dass die Strömungsmaschinenkomponente als die Schaufel vorzusehen besonders vorteilhaft ist.

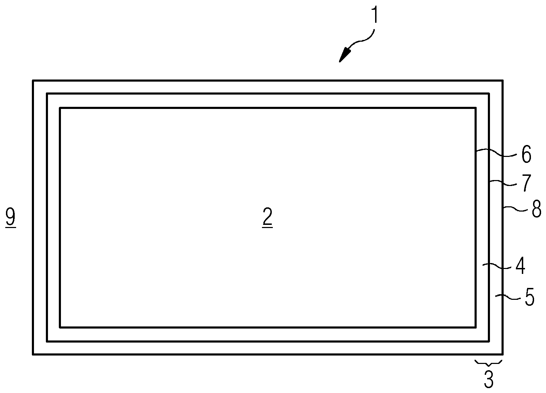

Im Folgenden wird anhand der beigefügten schematischen Zeichnung die Erfindung näher erläutert. Die Figur zeigt einen Querschnitt durch eine erfindungsgemäße Strömungsmaschinenkomponente.

Wie es aus der Figur ersichtlich ist, weist eine Strömungsmaschinenkomponente 1 einen Grundkörper 2 und eine Mehrlagenbeschichtung 3 auf. Der Grundkörper 2 weist einen Chromstahl auf und hat einen rechteckigen Querschnitt. Denkbar sind jedoch auch beliebige Formen des Grundkörpers 2 mit beliebigen Querschnitten. In der Figur ist die Mehrlagenbeschichtung 3 um den vollständigen Querschnitt des Grundkörpers 2 aufgebracht. Denkbar ist auch, dass die Mehrlagenbeschichtung lediglich an ausgewählten Stellen des Grundkörpers 2 aufgebracht ist.

Die Mehrlagenbeschichtung 3 weist eine Haftvermittlerschicht 4 und eine Schutzschicht 5 auf. Die Haftvermittlerschicht 4 weist Chromnitrid auf und ist unmittelbar auf den Grundkörper 2 aufgebracht. Zwischen dem Grundkörper 2 und der Haftvermittlerschicht 4 ist eine erste Grenzfläche 6 ausgebildet. Unmittelbar auf die Haftvermittlerschicht 4 ist eine Schutzschicht 5 aufgebracht. Zwischen der Haftvermittlerschicht 4 und der Schutzschicht 5 ist eine zweite Grenzfläche 7 ausgebildet. Die Schutzschicht 5 kann dabei entweder Chromnitrid, Chromaluminiumnitrid und/oder Titanaluminiumnitrid aufweisen.

In der Figur ist die Schutzschicht 5 als eine einzige Schutzschicht dargestellt, denkbar ist es jedoch auch, eine Mehrzahl von unmittelbar aufeinander aufgebrachten Schutzschichten vorzusehen. Erfindungsgemäß ist, dass die Mehrlagenbeschichtung dabei eine Schichtdicke von minimal 5 µm und maximal 35 µm hat. Dabei können alle Schutzschichten entweder Chromnitrid oder Chromaluminiumnitrid aufweisen oder die Schutzschichten können abwechselnd Chromnitrid und Chromaluminiumnitrid aufweisen.

Die einzelnen Schichten 4, 5 der Mehrlagenbeschichtung 3 sind jeweils mit einem physikalischen Gasphasenabscheideverfahren aufgebracht. Die Beschichtungstemperatur bei dem Gasphasenabscheideverfahren ist so gewählt, dass sie unterhalb der Anlasstemperatur des Grundkörpers 2 liegt, insbesondere wird die Beschichtungstemperatur niedriger als 600°C gewählt. Denkbar ist, dass zum Ausbilden der zweiten Grenzfläche 7 zwischen dem Aufbringen der Haftvermittlerschicht 4 und der Schutzschicht 5 die Temperatur der Haftvermittlerschicht 4 und des Grundkörpers 2 zeitweise abgesenkt wird.

Die Mehrlagenbeschichtung 3 weist eine Oberfläche 8 auf, die im Betrieb der Strömungsmaschine einem Medium 9 ausgesetzt ist. Ist dieses Medium 9 ein korrosives Medium so schützt die Mehrlagenbeschichtung 3 den Grundkörper vor einer Oxidation. Anhand mehrerer Beispiele wird im Folgenden die Erfindung näher erläutert, wobei die Strömungskomponente 1 eine Dampfturbinenschaufel ist

In einem erfindungsgemäßen Ausführungsbeispiel ist der Grundkörper 2 der Dampfturbinenschaufel aus einem Chromstahl gefertigt, der 10 Massenprozent Chrom, 1,0 Massenprozent Molybdän, 0,5 Massenprozent Nickel, 0,10 Massenprozent Vanadium und 88,4 Massenprozent Eisen aufweist. Der Grundkörper weist ein Schaufelblatt und einen Schaufelfuß auf. Unmittelbar auf die gesamte Oberfläche des Schaufelblatts ist eine 10 µm dicke Haftvermittlerschicht aufgebracht, die Chromnitrid aufweist. Unmittelbar auf die Haftvermittlerschicht ist eine erste Schutzschicht aufgebracht, die Chromaluminiumnitrid aufweist und 10 µm dick ist. Unmittelbar auf die erste Schutzschicht ist eine zweite Schutzschicht aufgebracht, die ebenfalls Chromaluminiumnitrid aufweist und 10 µm dick ist, so dass die aus den beiden Schutzschichten und der Haftvermittlerschicht bestehende Mehrlagenbeschichtung insgesamt eine Dicke von 30 µm hat. Die Haftvermittlerschicht und die beiden Schutzschichten sind dabei mittels eines physikalischen Gasphasenabscheideverfahrens bei einer Temperatur niedriger als 600°C aufgebracht.

In einem anderen Beispiel ist der Grundkörper 2 der Dampfturbinenschaufel aus einer Nickel-Basislegierung gefertigt und weist ein Schaufelblatt und einen Schaufelfuß auf. Unmittelbar auf die gesamte Oberfläche des Schaufelblatts ist eine 10 µm dicke Haftvermittlerschicht aufgebracht, die Chromnitrid aufweist. Unmittelbar auf die Haftvermittlerschicht ist eine Schutzschicht aufgebracht, die Titanaluminiumnitrid aufweist und 15 µm dick ist, so dass die aus der Schutzschicht und der Haftvermittlerschicht bestehende Mehrlagenbeschichtung insgesamt eine Dicke von 25 µm hat. Die Haftvermittlerschicht und die Schutzschicht sind dabei mittels eines physikalischen Gasphasenabscheideverfahrens bei einer Temperatur niedriger als 600°C aufgebracht.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Strömungsmaschinenkomponente mit einem einen Chromstahl aufweisenden Grundkörper (2) und einer auf den Grundkörper (2) unmittelbar aufgebrachten Mehrlagenbeschichtung (3), die minimal 5 µm und maximal 35 µm dick ist sowie eine Mehrzahl von unmittelbar aufeinander aufgebrachter Schichten (4, 5) aufweist,
wobei die unmittelbar auf den Grundkörper aufgebrachte Schicht eine Haftvermittlerschicht (4) ist, die Chromnitrid aufweist, und mindestens eine der verbliebenen Schichten (5) einen Hartstoff aufweist, der Chromnitrid, Chromaluminiumnitrid und/oder Titanaluminiumnitrid aufweist.

2. Strömungsmaschinenkomponente gemäß Anspruch 1,
wobei der Massengehalt an Chrom in dem Chromstahl minimal 8% und maximal 13% beträgt.

3. Strömungsmaschinenkomponente gemäß Anspruch 1 oder 2,
wobei der Chromstahl ein martensitischer Chromstahl ist.

4. Strömungsmaschinenkomponente gemäß einem der Ansprüche 1 bis 3,
wobei der Chromstahl Stickstoff aufweist.

5. Strömungsmaschinenkomponente gemäß Anspruch 4,
wobei der Massengehalt an Stickstoff in dem Chromstahl minimal 0,010% und maximal 0,080% beträgt.

6. Strömungsmaschinenkomponente gemäß einem der Ansprüche 1 bis 5,
wobei der Chromstahl Molybdän und/oder Vanadium aufweist.

7. Strömungsmaschinenkomponente gemäß Anspruch 6,
wobei der Chromstahl von 9,0 bis 11,0 Massenprozent Chrom, von 1,0 bis 2,0 Massenprozent Molybdän, von 0,1 bis 1,0 Massenprozent Nickel, von 0,10 bis 0,30 Massenprozent Vanadium und als restlichen Bestandteil im Wesentlichen Eisen aufweist.

8. Strömungsmaschinenkomponente gemäß einem der Ansprüche 1 bis 7,
wobei die Schichten (4, 5) der Mehrlagenbeschichtung (3) mittels eines physikalischen Gasphasenabscheideverfahrens aufgebracht sind.

9. Strömungsmaschinenkomponente gemäß Anspruch 8,
wobei das physikalische Gasphasenabscheideverfahren bei einer Beschichtungstemperatur von niedriger als 600°C durchgeführt wird.

10. Strömungsmaschinenkomponente gemäß einem der Ansprüche 1 bis 9,
wobei die Strömungsmaschinenkomponente (1) eine Laufschaufel oder eine Leitschaufel einer Dampfturbine ist.

## Claims

1. Turbomachine component having a main body (2) comprising a chromium steel and a multilayer coating (3), which is applied directly to the main body (2), has a thickness of at least 5 µm and at most 35 µm and also has a plurality of layers (4, 5) applied directly to one another,
wherein the layer applied directly to the main body is an adhesion promoting layer (4) comprising chromium nitride, and at least one of the remaining layers (5) comprises a hard material which comprises chromium nitride, chromium aluminum nitride and/or titanium aluminum nitride.

2. Turbomachine component according to Claim 1,
wherein the content of chromium in the chromium steel is at least 8% by mass and at most 13% by mass.

3. Turbomachine component according to Claim 1 or 2,
wherein the chromium steel is a martensitic chromium steel.

4. Turbomachine component according to one of Claims 1 to 3,
wherein the chromium steel comprises nitrogen.

5. Turbomachine component according to Claim 4,
wherein the content of nitrogen in the chromium steel is at least 0.010% by mass and at most 0.080% by mass.

6. Turbomachine component according to one of Claims 1 to 5,
wherein the chromium steel comprises molybdenum and/or vanadium.

7. Turbomachine component according to Claim 6,
wherein the chromium steel comprises from 9.0 to 11.0% by mass chromium, from 1.0 to 2.0% by mass molybdenum, from 0.1 to 1.0% by mass nickel, from 0.10 to 0.30% by mass vanadium and substantially iron as the remaining constituent.

8. Turbomachine component according to one of Claims 1 to 7,
wherein the layers (4, 5) of the multilayer coating (3) are applied by means of a physical vapor deposition process.

9. Turbomachine component according to Claim 8,
wherein the physical vapor deposition process is carried out at a coating temperature of less than 600°C.

10. Turbomachine component according to one of Claims 1 to 9,
wherein the turbomachine component (1) is a rotor blade or a guide vane of a steam turbine.

## Revendications

1. Elément de turbomachine, comprenant un corps (2) de base ayant un acier au chrome et un revêtement (3) à plusieurs couches, disposé directement sur le corps (2) de base, qui a une épaisseur au minimum de 5 µm et au maximum de 35 µm, ainsi qu'une pluralité de couches (4, 5) déposées directement les unes sur les autres,
dans lequel la couche déposée directement sur le corps de base est une couche (4) d'agent adhésif, qui a du nitrure de chrome, et au moins l'une des couches (5) restantes a une matière dure, qui a du nitrure de chrome, du nitrure de chrome et d'aluminium et/ou du nitrure de titane et d'aluminium.

2. Elément de turbomachine suivant la revendication 1,
dans lequel la teneur en masse du chrome de l'acier au chrome est au minimum de 8% et au maximum de 13%.

3. Elément de turbomachine suivant la revendication 1 ou 2,
dans lequel l'acier au chrome est un acier au chrome martensitique.

4. Elément de turbomachine suivant l'une des revendications 1 à 3,
dans lequel l'acier au chrome a de l'azote.

5. Elément de turbomachine suivant la revendication 4,
dans lequel la teneur en masse d'azote de l'acier au chrome est au minimum de 0,010% et au maximum de 0, 080%.

6. Elément de turbomachine suivant l'une des revendications 1 à 5,
dans lequel l'acier au chrome a du molybdène et/ou du vanadium.

7. Elément de turbomachine suivant la revendication 6,
dans lequel l'acier au chrome a un pourcentage en masse de chrome de 9,0 à 11,0, un pourcentage en masse de molybdène de 1,0 à 2,0, un pourcentage en masse de nickel de 0,1 à 1,0, un pourcentage en masse de vanadium de 0,10 à 0,30 et a, comme constituant restant, essentiellement du fer.

8. Elément de turbomachine suivant l'une des revendications 1 à 7,
dans lequel les couches (4, 5) du revêtement (3) à plusieurs couches sont déposées au moyen d'un procédé de dépôt physique en phase gazeuse.

9. Elément de turbomachine suivant la revendication 8,
dans lequel le procédé de dépôt physique en phase gazeuse est effectué à une température de revêtement plus basse que 600°C.

10. Elément de turbomachine suivant l'une des revendications 1 à 9,
dans lequel l'élément (1) de turbomachine est une aube mobile ou une aube directrice d'une turbine à vapeur.
